# EUROPÄISCHE PATENTSCHRIFT

(11) **EP 3 161 882 B1**
(45) Veröffentlichungstag und Bekanntmachung des Hinweises auf die Patenterteilung: **28.03.2018**
(21) Anmeldenummer: 15725077.0
(22) Anmeldetag: 03.06.2015
(51) Int. Cl.: H01L 39/24, C23C 18/12

(54) **VERFAHREN ZUR HERSTELLUNG EINES KOMPOSITS UMFASSEND EINE HOCHTEMPERATURSUPRALEITER(HTS)-SCHICHT**
METHOD FOR MANUFACTURING A COMPOSITE COMPRISING A HIGH-TEMPERATURE SUPRACONDUCTOR (HTS) LAYER
PROCÉDÉ DE FABRICATION D'UN COMPOSITE CONSTITUÉ D'UNE COUCHE À SUPRACONDUCTEUR HAUTE TEMPÉRATURE (HTS)

(30) Priorität: 24.06.2014 EP 14173771
(43) Veröffentlichungstag der Anmeldung: 03.05.2017
(73) Patentinhaber: BASF SE, 67056 Ludwigshafen am Rhein (DE)
(72) Erfinder: FALTER, Martina, 53913 Swisttal-Buschhoven (DE); THIEMS, Oliver, 53225 Bonn (DE); BÄCKER, Michael, 50670 Köln (DE)
(86) Internationale Anmeldenummer: PCT/EP2015/062414
(87) Internationale Veröffentlichungsnummer: WO 2015/197334

(56) Entgegenhaltungen:
- EP-A1- 1 667 174
- DE-A1-102004 041 053
- DE-A1-102008 004 818
- US-A1- 2010 015 340
- OBRADORS X ET AL: "Progress towards all-chemical superconducting YBa2Cu3O7-coated conductors", SUPERCONDUCTOR SCIENCE AND TECHNOLOGY, IOP PUBLISHING, TECHNO HOUSE, BRISTOL, GB, Bd. 19, Nr. 3, 1. März 2006 (2006-03-01), Seiten S13-S26, XP020100846, ISSN: 0953-2048, DOI: 10.1088/0953-2048/19/3/003
- KNOTH ET AL: "Chemical solution deposition of YBa2Cu3O7-x coated conductors", CURRENT OPINION IN SOLID STATE AND MATERIALS SCIENCE, ELSEVIER SCIENCE LTD, OXFORD, GB, Bd. 10, Nr. 5-6, 19. September 2007 (2007-09-19), Seiten 205-216, XP022258482, ISSN: 1359-0286
- GRIVEL J-C ET AL: "Preparation and characterization of Bi2Sr2CaCu2O8+[delta]thin films on MgO single crystal substrates by chemical solution deposition", PHYSICA C, NORTH-HOLLAND PUBLISHING, AMSTERDAM, NL, Bd. 486, 20. Januar 2013 (2013-01-20), Seiten 32-36, XP028529260, ISSN: 0921-4534, DOI: 10.1016/J.PHYSC.2013.01.002
- DAWLEY J T ET AL: "Thick Sol-gel Derived YBa2Cu3O7-[delta] Films", IEEE TRANSACTIONS ON APPLIED SUPERCONDUCTIVITY, IEEE SERVICE CENTER, LOS ALAMITOS, CA, US, Bd. 11, Nr. 1, 1. März 2001 (2001-03-01), Seiten 2873-2876, XP011090933, ISSN: 1051-8223, DOI: 10.1109/77.919662

## Beschreibung

### Technisches Gebiet

Die Erfindung betrifft ein Verfahren zur Herstellung eines Komposits umfassend eine Hochtemperatursupraleiter(HTS)-Schicht sowie ein mit einem solchen Verfahren erhältliches Produkt.

### Stand der Technik

Bandförmige Hochtemperatursupraleiter (HTS), auch als Coated Conductors bezeichnet, umfassen einen bandförmigen (üblicherweise metallischen) Träger, auf den, ggf. nach vorherigem Aufbringen einer oder mehrerer Zwischen- oder Pufferschichten, mindestens eine supraleitende Funktionsschicht aufgebracht wird.

Ein wesentlicher Punkt bei der Herstellung von Coated Conductors ist das Erfordernis, dass die supraleitende Schicht eine extrem hohe biaxiale Textur, d. h. kristallographische Orientierung, aufweisen muss. Die einzelnen Kristallite der supraleitenden Schicht dürfen dabei nur geringfügig gegeneinander verkippt sein, um die supraleitenden Eigenschaften nicht zu beeinträchtigen (High Temperature Superconductivity 1: Materials, A.V. Narlikar (Hrg.) Springer-Verlag, 2004, 115-167).

Um einen solchen hohen Texturgrad zu erreichen, werden zwei unterschiedliche Herstellungsansätze verfolgt. Bei beiden Ansätzen werden metallische Träger verwendet, weil nur so die für die spätere Verwendung erforderliche Festigkeit der Endprodukte erreicht werden kann. Darüber hinaus wird bei beiden Ansätzen vor dem Aufbringen der supraleitenden Schicht mindestens eine biaxial texturierte Zwischen- oder Pufferschicht erzeugt, die ihre Textur an die supraleitende Schicht bei deren Ausbildung überträgt.

Beim ersten Ansatz wird von einem untexturierten, d. h. kristallographisch nicht-orientierten, metallischen Träger ausgegangen, auf den anschließend die Pufferschicht mit einer Orientierung aufgebracht wird. Eine solche gerichtete Abscheidung kann nur mittels physikalischer Beschichtungsverfahren, z. B. Ion Beam Assisted Deposition (IBAD) und Inclined Substrate Deposition (ISD), im Hochvakuum erfolgen. Diese Verfahren sind jedoch mit einem hohen apparativen Aufwand verbunden.

Beim zweiten Ansatz wird der metallische Träger bereits durch spezielle Verfahren biaxial texturiert (siehe z. B. DE 101 43 680 C1, CN 1 117 879 C, DE 100 05 861 A1). Diese Textur des Trägers wird dann in den nachfolgenden Schritten zunächst auf die Pufferschicht und von dort auf die supraleitende Schicht übertragen. Da für das Aufbringen der weiteren Schichten keine gerichteten Abscheideverfahren verwendet werden müssen, können hier sowohl physikalische Verfahren als auch insbesondere chemische Verfahren, wie Chemical Solution Deposition (CSD), eingesetzt werden.

Besonders wirtschaftlich, sowohl im Hinblick auf Anlagen- als auch Betriebskosten, sind chemische Verfahren, wie das CSD-Verfahren, da diese üblicherweise bei Normaldruck arbeiten und eine hohe Abscheiderate ermöglichen. Im Mittelpunkt gegenwärtiger Entwicklungsarbeiten stehen daher Herstellungsprozesse für Coated Conductors, bei denen auf einen texturierten metallischen Träger über chemische Abscheidung zunächst eine oder mehrere Pufferschichten und anschließend die supraleitende Schicht aufgebracht werden. Durch abschließende Kristallisationsglühung wird dann erreicht, dass die biaxiale Textur der darunter liegenden Schicht bzw. des metallischen Trägers übertragen wird.

Die Funktion der Pufferschicht bzw. der Pufferschichten besteht zum einen darin, die Korrosion des Metalls durch Oxidation zu verhindern, wodurch die Orientierung verloren ginge. Zum anderen muss die Diffusion von Metallionen wie Nickel oder Eisen in die supraleitende Schicht verhindert werden, um deren Qualität nicht zu beeinträchtigen. Im schlimmsten Fall würden die supraleitenden Eigenschaften des Materials verloren gehen.

Wie bereits ausgeführt, bietet sich für das Abscheiden der Pufferschichten (sowie später auch für das Abscheiden der supraleitenden Schicht) ein CSD-Verfahren an. CSD-Verfahren sind leicht reproduzierbar und mit geringem technischem Aufwand aufskalierbar. Die Wachstumsraten der Schichten sind deutlich höher als bei physikalischen Aufdampfverfahren, so dass der Durchsatz an Material höher ist, was weitere ökonomische Vorteile mit sich bringt. Derzeit ist es möglich, bandförmige Hochtemperatursupraleiter mit mehreren Hundert Metern Länge mit einem CSD-Verfahren herzustellen.

Bei CSD-Verfahren können grundsätzlich die folgenden drei Schritte unterschieden werden:
1. Abscheidung der Beschichtungslösung
2. Trocknung und Pyrolyse
3. Reaktion und Kristallisation

Insbesondere für HTS-Schichten ist die Herstellung möglichst dicker (> 1 µm), homogener und orientiert kristalliner Schichten das Ziel, um hohe kritische Ströme zu transportieren.

Wird die HTS-Schicht in einem Durchgang aufgebracht, gestaltet sich die Pyrolyse sehr komplex und benötigt relativ lange Zeiträume von einer Stunde oder mehr. Zudem können sich bei höheren Pyrolysedauern Gradienten in der Elementverteilung über die gesamte Schichtdicke ergeben und so die nötigen Diffusionswege in der Kristallisationsreaktion vergrößern.

Die Schritte 1 und 2 werden daher vorteilhaft in mehreren Durchgängen mit jeweils dünnen Schichten ausgeführt, da bei Trocknung und Pyrolyse große Gasmengen frei werden. Durch das Aufbringen in mehreren Durchgängen entstehen weitgehend riss- und porenfreie intermediäre Schichten.

Aus dem Stand der Technik (siehe z.B. EP 1667174 A1) sind hierzu Verfahren bekannt, bei denen bis zu zehn (10) Schichten mit einer Dicke von ca. 100 nm (als Maximum werden 300 nm angegeben) aufgebracht werden. Diese Verfahren sind allerdings sehr zeit- und kostenaufwändig.

Wenn man versucht, die Schritte 1 und 2 mit dickeren Schichten (> 300 nm) durchzuführen, um den Zeit- und Kostenaufwand zu reduzieren, stellt es sich aber als problematisch heraus, dass sich durch Transportprozesse an der Oberfläche der pyrolysierten Schichten Konzentrationsgradienten bilden können, was z. B. durch unterschiedlich volatile Precursoren/metallorganische Komplexe insbesondere im Pyrolyseschritt hervorgerufen wird. Dies gilt beispielsweise besonders ausgeprägt für Kupfer-Fluor-organische Komplexe. Dabei kommt es insbesondere zu einer Anreicherung von CuO in der Grenzschicht. Diese Gradienten verhindern im nachfolgenden Kristallisationsschritt die durchgehende homogene Kristallisation über die Grenzschichten hinweg.

Schritt 3 dagegen kann nur in einem Schritt durchgeführt werden, da sich bei der Kristallisation dicker Schichten (> 1 µm) Fremdphasen an der Wachstumsfront aufkonzentrieren (ähnlich einem Zonenschmelzprozess). Dadurch sind die Oberflächen dieser Schicht nicht mehr für nachfolgendes epitaktisches Wachstum geeignet.

### Aufgabe der Erfindung

Der Erfindung liegt daher die Aufgabe zugrunde, die zuvor genannten Probleme zu lösen, d. h. bei Filmen, die nach dem Auftrag und der Wärmebehandlung der einzelnen Teilschichten einem gemeinsamen Kristallisationsprozess unterzogen werden, zu ermöglichen, dass sich Kristalle über die Grenzschicht zwischen den Teilschichten hinweg bilden, um eine homogene Kristallisation der Gesamtschicht zu erreichen.

### Gegenstand der Erfindung

Erfindungsgemäß wird diese Aufgabe mit einem Verfahren zur Herstellung eines Komposits umfassend eine Hochtemperatursupraleiter(HTS)-Schicht auf der Basis von Seltenerdmetall-Barium-Kupferoxid auf einem Substrat mit vorgegebener biaxialer Textur gelöst, das die folgende Schritte umfasst:
A) Aufbringen einer ersten HTS-Beschichtungslösung auf das Substrat;
B) Trocknen der ersten HTS-Beschichtungslösung zur Herstellung eines ersten Films;
C) Pyrolysieren des ersten Films zur Herstellung einer ersten pyrolysierten Teilschicht;
D) Abtragen einer Grenzschicht auf der Oberseite der ersten pyrolysierten Teilschicht zur Herstellung einer ersten pyrolysierten Teilschicht mit reduzierter Schichtdicke;
E) Aufbringen einer zweiten HTS-Beschichtungslösung auf der ersten pyrolysierten Teilschicht mit reduzierter Schichtdicke;
F) Trocknen der zweiten HTS-Beschichtungslösung zur Herstellung eines zweiten Films;
G) Pyrolysieren des zweiten Films zur Herstellung einer zweiten pyrolysierten Teilschicht;
H) gegebenenfalls Ausbilden einer oder mehrerer weiterer pyrolysierter Teilschichten auf der zweiten pyrolysierten Teilschicht; und
I) Kristallisieren der aus den pyrolysierten Teilschichten gebildeten Gesamtschicht zur Fertigstellung der HTS-Schicht,
wobei das Abtragen der Grenzschicht in Schritt D) so erfolgt, dass (bei Durchführung der besagten Folgeschritte) in die erste und auch in die zweite pyrolysierte Teilschicht eine Textur übertragen wird, welche durch die vorgegebene biaxiale Textur des Substrats bestimmt ist. Schritt I) ist dabei der Schritt, in dem mit dem Kristallisieren die Textur übertragen wird. Schritt D) ermöglicht die Übertragung der Textur.

Dabei wird in dieser Anmeldung unter "Substrat" jedes Trägermaterial für eine HTS-Schicht verstanden. Dabei kann es sich insbesondere um einen metallischen Träger oder eine Zwischen- oder Pufferschicht handeln, wie sie per se aus dem Stand der Technik bekannt sind.

Unter dem Begriff "HTS-Beschichtungslösung" wird in dieser Anmeldung jede Lösung verstanden, die nach Aufbringen, Trocknen, Pyrolysieren und Kristallisieren eine HTS-Schicht ergibt.

Das erfindungsgemäße Verfahren ermöglicht in überraschend einfacher und effektiver Weise eine Homogenisierung von Gesamtschichten, die in mindestens zwei Teilschichten übereinander abgeschieden und noch nicht einer gemeinsamen Kristallisation unterzogen worden sind, und zwar durch Zwischenbehandlung(en) nach jedem Teilschritt in Form der Entfernung vorhandener Grenzschichten.

Diese Zwischenbehandlung(en) soll(en) oberflächlich vorhandene Grenzbereiche mit inhomogenen Materialeigenschaften abtragen. Die Inhomogenität kann sich auf eine Abweichung in der Elementverteilung und/oder auf eine Abweichung in der dort auftretenden Stoffverbindung bzw. den dort auftretenden Oxidationsstufen beziehen.

Die Erfindung kommt nur dann zum Tragen, wenn bei jeder oder mindestens einer der aufgetragenen und individuell prozessierten Teilschichten zum Zeitpunkt der Fertigung eine Grenzschicht ausgebildet wird, die sich vom Rest der Teilschicht eindeutig anhand von messbaren Parametern unterscheidet, so dass eine gezielte Abtragung erfolgen kann.

In einer bevorzugten Ausbildung der Erfindung wird Schritt H) durchgeführt, wobei unmittelbar zuvor ein Abtragen einer Grenzschicht auf der Oberseite der jeweils vorherigen, zweiten oder weiteren pyrolysierten Teilschicht erfolgt.

Bevorzugt ist vorgesehen, dass in Schritt D) soviel von der ersten pyrolysierten Teilschicht als Grenzschicht abgetragen wird, dass nach dem Abtragen der Mittelwert des atomaren Verhältnisses (Ba + Cu) : Y in den oberen 10 nm der ersten pyrolysierten Teilschicht unter 8 liegt und/oder vor Schritt H) soviel von der jeweils vorherigen, zweiten oder weiteren Teilschicht als Grenzschicht abgetragen wird, dass nach dem Abtragen der Mittelwert des atomaren Verhältnises (Ba + Cu) : Y in den oberen 10 nm der jeweils vorherigen, zweiten oder weiteren Teilschicht unter 8 liegt.

Die Entfernung der kupfer- und bariumreichen Grenzschicht in diesem Umfang stellt ein optimales Durchwachsen der Kristallisation durch die jeweilige Teilschicht sicher, ohne dass zuviel Material entfernt werden muss, wie aus den in den Beispielen unten erläuterten spektroskopischen Messungen erkennbar ist.

Die besten Ergebnisse werden erzielt, wenn der Mittelwert des atomaren Verhältnisses (Ba + Cu) : Y sogar unter 6 liegt.

Bevorzugt ist auch vorgesehen, dass in Schritt D) 1 bis 20% der ersten pyrolysierten Teilschicht als Grenzschicht abgetragen werden, bezogen auf die Schichtdicke der ersten pyrolysierten Teilschicht, und/oder vor Schritt H) 1 bis 20% der jeweils vorherigen, zweiten oder weiteren pyrolysierten Teilschicht als Grenzschicht abgetragen werden, bezogen auf die Schichtdicke der jeweils vorherigen, zweiten oder weiteren Teilschicht.. Mit dieser Maßnahme kann ebenfalls sichergestellt werden, dass die für die Durchkristallisation der Gesamtschicht störenden Grenzschichten in ausreichendem Maße entfernt werden, ohne dass ein zu großer Materialverlust entsteht.

Bevorzugt beträgt der Abtrag 1 bis 10%, besonders bevorzugt 2 bis 5%.

Das Abtragen der Grenzschicht erfolgt vorzugsweise auf mechanischem, chemischem und/oder physikalischem Wege.

Das Abtragen der Grenzschicht erfolgt dabei bevorzugt durch Ultraschall, Abrasion, Bestrahlung, Ätzen, Beizen, Plasmaätzen oder Lösen in einem geeigneten Lösungsmittel, gegebenenfalls in Kombination miteinander oder mit anderen mechanischen, chemischen oder physikalischen Behandlungsschritten.

In einer besonders bevorzugten Ausführungsform der Erfindung ist dabei vorgesehen, dass das Abtragen der Grenzschicht mit Ultraschall in einem geeigneten Lösungsmittel, bevorzugt einem Alkohol, besonders bevorzugt Ethanol erfolgt.

In einer alternativen Ausführungsform kann das Abtragen der Grenzschicht durch Bürsten und/oder Wischen erfolgen.

Weiterhin kann erfindungsgemäß vorgesehen sein, dass zum Abtragen der Grenzschicht Plasma, Partikel-, Teilchen-, Atom- und/oder Molekülstrahlen eingesetzt werden.

In einer besonders bevorzugten Ausführungsform der Erfindung kann vorgesehen sein, dass als HTS-Beschichtungslösung eine Lösung zur Ausbildung einer Seltenerd-Barium-Kupferoxid Schicht, insbesondere einer Yttrium-Barium-Kupferoxid-Schicht verwendet wird.

Erfindungsgemäß ist bevorzugt, dass insgesamt 2, 3, 4 oder 5, besonders bevorzugt 2 oder 3 pyrolysierte Teilschichten ausgebildet werden.

Im Rahmen der Erfindung kann vorgesehen sein, dass die Zusammensetzungen der jeweiligen Beschichtungslösungen unterschiedlich sind.

Damit kann eine gezielte Stöchiometrievariation innerhalb der aus Teilschichten aufgebauten Gesamtschicht erreicht werden, was für bestimmte Zwecke höchst wünschenswert sein kann (siehe Beispiel 4).

Es kann erfindungsgemäß auch vorgesehen sein, dass die pyrolysierten Teilschichten in unterschiedlichen Schichtdicken ausgebildet werden.

Die Schichtdicken der pyrolysierten Teilschichten liegen dabei bevorzugt zwischen 400 und 800 nm.

Es ist erfindungsgemäß besonders bevorzugt, dass die Gesamtschicht in einer Schichtdicke von zwischen 800 und 2000 nm ausgebildet wird. Die Erfindung betrifft weiterhin ein Komposit, umfassend auf einem Substrat mit vorgegebener Textur eine Hochtemperatursupraleiter(HTS)-Schicht umfassend Seltenerd-Barium-Kupferoxid,
wobei
- die HTS-Schicht aus mehreren aufeinander abgeschiedenen Teilschichten besteht,
- in jeder der Teilschichten in Richtung senkrecht zur Substratoberfläche das atomare Verhältnis (Ba + Cu) : Y variiert und
- in jeder der Teilschichten, mit oder ohne Ausnahme der obersten Teilschicht, jede sich parallel zur Substratoberfläche erstreckende Sub-Schicht einer Dicke von 10 nm so konstituiert ist, dass der Mittelwert des besagten atomaren Verhältnisses kleiner oder gleich 8 ist.

Gemäß einer ersten Alternative gilt somit, dass in jeder der Teilschichten (ohne Ausnahme der obersten Teilschicht, d.h. einschließlich der obersten Teilschicht) jede sich parallel zur Substratoberfläche erstreckende Sub-Schicht einer Dicke von 10 nm so konstituiert ist, dass der Mittelwert des besagten atomaren Verhältnisses kleiner oder gleich 8 ist. Bei dieser Alternative gilt also auch für die oberste Teilschicht, dass jede sich parallel zur Substratoberfläche erstreckende Sub-Schicht einer Dicke von 10 nm so konstituiert ist, dass der Mittelwert des besagten atomaren Verhältnisses kleiner oder gleich 8 ist.

Und gemäß einer zweiten Alternative gilt somit, dass in jeder der Teilschichten, mit Ausnahme der obersten Teilschicht, jede sich parallel zur Substratoberfläche erstreckende Sub-Schicht einer Dicke von 10 nm so konstituiert ist, dass der Mittelwert des besagten atomaren Verhältnisses kleiner oder gleich 8 ist. Die oberste Teilschicht kann bei dieser Alternative anders konstituiert sein, insbesondere weil die kupferreiche Grenzschicht nicht abgetragen wurde.

Dabei ist das erfindungsgemäße Komposit bevorzugt herstellbar mit dem erfindungsgemäßen Verfahren.

Bevorzugt ist ein Komposit, bei dem die Gesamtschicht aus pyrolysierten Teilschichten nach dem Kristallisieren in Schritt I) in mehr als 80% des Volumens eine Textur aufweist, die durch die vorgegebene Textur des Substrats definiert ist.

Besonders bevorzugt ist das Komposit ein bandförmiger HTS.

Die nachfolgenden Zeichnungen dienen der weiteren Erläuterung der Erfindung. Dabei zeigt:
Fig. 1 eine schematische Darstellung der Ergebnisse von FIB-TEM-EDX-Messungen an übereinander aufgebrachten YBCO-Teilschichten (Fig. 1A ohne Zwischenreinigung, Fig. 1B mit Zwischenreinigung);
Fig. 2 die Ionenkonzentration in einer YBCO-Schicht ohne (links) und mit (rechts) Ultraschallbehandlung in Ethanol;
Fig. 3 das Cu:Y- bzw. Ba:Y-Verhältnis in einer YBCO-Einzelschicht (links), einer YBCO-Einzelschicht nach Ultraschallbehandlung (Mitte) und einer YBCO-Doppelschicht nach Ultraschallbehandlung (rechts), bestimmt aus der Spüllösung mit ICP-OES,
Fig. 4 das SEM(Scanning Electron Microscopy)-Bild einer YBCO-Doppelschicht nach Kristallisation ohne (Fig. 4A) und mit (Fig.4B) Zwischenreinigung durch Ultraschall in Ethanolund
Fig. 5 eine nicht-maßstabsgerechte, schematische Darstellung eines erfindungsgemäßen Komposits.

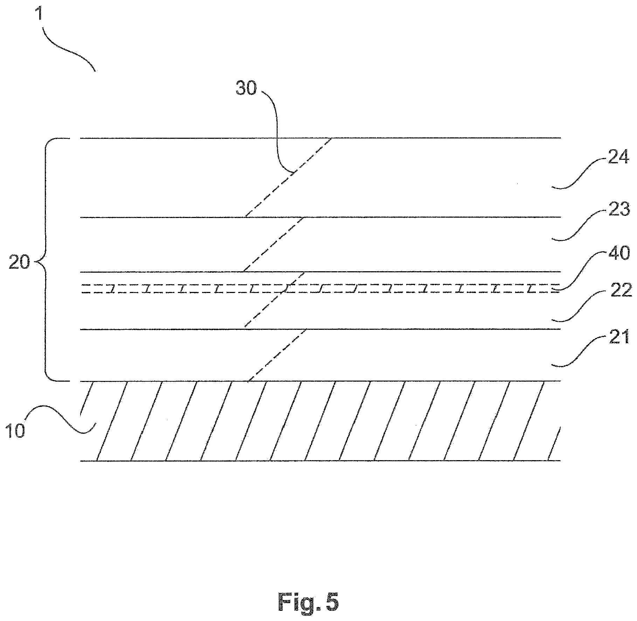

Ein beispielhaftes Komposit 1, wie es mit dem erfindungsgemäßen Verfahren herstellbar ist, ist in Fig. 5 dargestellt. Dabei ist auf dem Substrat 10 eine HTS-Schicht 20 mit insgesamt vier Teilschichten 21, 22, 23 und 24 aufgebracht. Bei den ersten drei Teilschichten 21, 22 und 23 ist jeweils vor dem Aufbringen der nächsten Teilschicht die oben beschriebene und in den Beispielen unten noch näher erläuterte Zwischenreinigung zum Abtragen der kupferreichen Grenzschicht vorgenommen worden. Die oberste Teilschicht 24 ist dieser Behandlung nicht unterworfen worden.

Die über die Teilschichten variierenden atomaren Verhältnisse (Ba + Cu) : Y sind in jeder der Teilschichten durch die schräg verlaufenden gestrichelten Linien 30 schematisch angedeutet. Zur Charakterisierung des erfindungsgemäßen Komposits wird nunmehr in einer der Teilschichten 21, 22, 23 in einem parallel zum Substrat 10 verlaufenden, an beliebiger Stelle in einer der Teilschichten positionierten Sub-Schicht 40 (in Fig. 5 beispielhaft in Teilschicht 22) mit den in den Beispielen unten näher beschriebenen Verfahren der Mittelwert des genannten atomaren Verhältnisses bestimmt. Dabei erweist sich, dass dieser beim erfindungsgemäßen Komposit in allen Teilschichten (21, 22, 23) - mit Ausnahme der obersten Teilschicht (24), bei der in diesem Ausführungsbeispiel kein Abtragen der kupferreichen oberen Grenzschicht stattgefunden hat - den Wert von 8 nie überschreitet. Selbstverständlich kann aber auch die oberste Teilschicht 24 so gestaltet sein, dass der besagte Wert nicht überschritten wird.

Weitere Merkmale und Vorteile der Erfindung ergeben sich aus den nachfolgenden Beispielen:

### Beispiel 1

Bei der Herstellung von biaxial texturierten Yttrium-Barium-Kupferoxid(YBCO)-Schichten im CSD-Verfahren bildet sich nach der Pyrolyse der Einzelschichten eine Ba- und Cu-reiche Grenzschicht aus. Das Seltenerdmetall, in diesem Falle Yttrium, ist dort kaum vertreten.

Sollen zwei oder mehr Schichten übereinander abgeschieden und gemeinsam kristallisiert werden, muss bei einer heterogenen Kristallisation die an der Grenzfläche zwischen dem Träger oder der Pufferschicht und der HTS-Schicht entstehende Kristallisationsfront über den inhomogenen Grenzbereich zwischen den einzeln abgeschiedenen Teilschichten hinüberwachsen. Im Grenzbereich liegt eine höhere Cu-Konzentration vor als im Rest der Schicht, wahrscheinlich als CuO. Zur gewünschten Kristallisation zu YBa₂Cu₃Oₓ(6<x<7) müsste Cu oxidieren, was aber bei den angewendeten Kristallisationsbedingungen nicht gelingt. Diese Blockade verhindert ein gleichmäßiges Durchkristallisieren der Gesamtschicht. Dabei ist zu beobachten, dass oberhalb der Grenzschichten falsch texturiertes, polykristallines Material häufiger auftritt und der Anteil der Fremdphasen höher ist.

Erfindungsgemäß wird nunmehr so vorgegangen, dass zunächst eine erste YBCO-Einzelschicht aus Lösung abgeschieden, getrocknet und pyrolysiert wird, mit einem für derartige Verfahren üblichen Temperaturprofil. Abscheidung, Trocknung und Pyrolyse finden direkt aufeinanderfolgend in der gleichen Anlage (Reel-to-Reel-Pyrolyseofen) statt. Die Pyrolyse erfolgt unter einem Gasstrom von 500 I/h N₂ + 200 I/h O₂ + 12 g/h H₂O. Dabei bildet sich unweigerlich eine Grenzschicht, die an Cu und Ba angereichert ist und üblicherweise zwischen 1 und 10 % der Schicht ausmacht, maximal 20 %.

Im nächsten Schritt wird dieser Grenzbereich, im vorliegenden Beispiel durch Ultraschallbehandlung (30 m/h) in Ethanol (Behandlungszeit: ca. 2 min), abgetragen. Nach dieser Zwischenbehandlung wird die nächste Teilschicht unter denselben Bedingungen abgeschieden, getrocknet und pyrolysiert. Wenn die Abscheidung einer weiteren Teilschicht darüber beabsichtigt ist, erfolgt an dieser Stelle zunächst erneut das Abtragen der Grenzschicht. Ansonsten wird die homogenisierte Gesamtschicht nunmehr unter einem Gasstrom von 400 I/h N₂, angefeuchtet mit 23 g/h H₂O, + 1,4 I/h O₂ + 220 I/h N₂ (trocken) mit einem für derartige Verfahren üblichen Temperaturprofil durchkristallisiert. Dabei kann je nach zu prozessierender Länge des Werkstückes im Vakuum oder ohne Vakuum gearbeitet werden. Das Resultat ist ein homogenes, texturiertes Kristallwachstum durch das gesamte Schichtpaket hindurch.

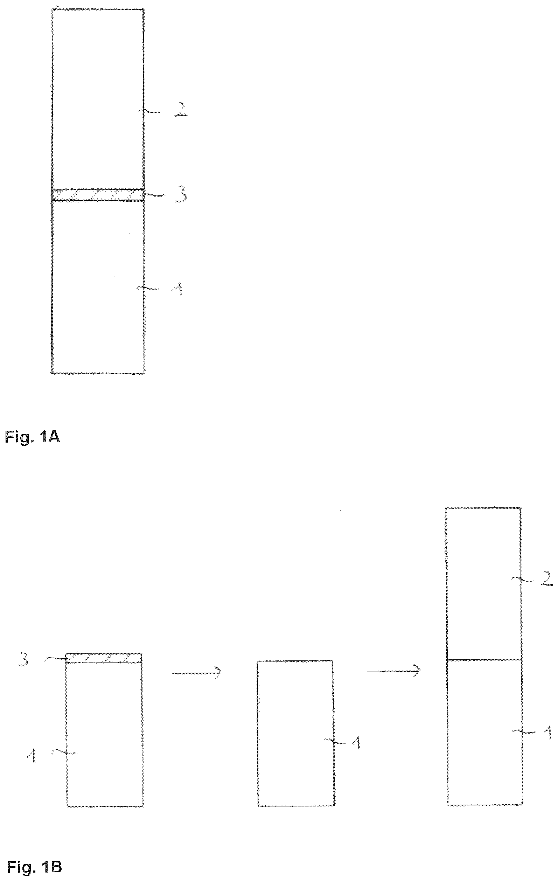

Zur Verdeutlichung des Effektes der Zwischenbehandlung sind in Fig. 1 die Ergebnisse von FIB(Focused Ion Beam)-TEM(Transmission Electron Microscopy)-EDX(Energy Dispersive X-Ray Spectroscopy)-Messungen, schematisch dargestellt, wobei sich Fig. 1A auf Messungen an zwei Teilschichten 1 und 2 übereinander ohne Zwischenreinigung und Fig. 1B auf Messungen an zwei Teilschichten 1 und 2 mit Zwischenreinigung bezieht. Durch diese Zwischenreinigung wird die als schraffierter Streifen 3 in Fig. 1A deutlich zu sehende kupferoxidreiche Grenzschicht effektiv entfernt, die ansonsten die Durchkristallisation von Teilschicht 1 in Teilschicht 2 hinein beeinträchtigen würde.

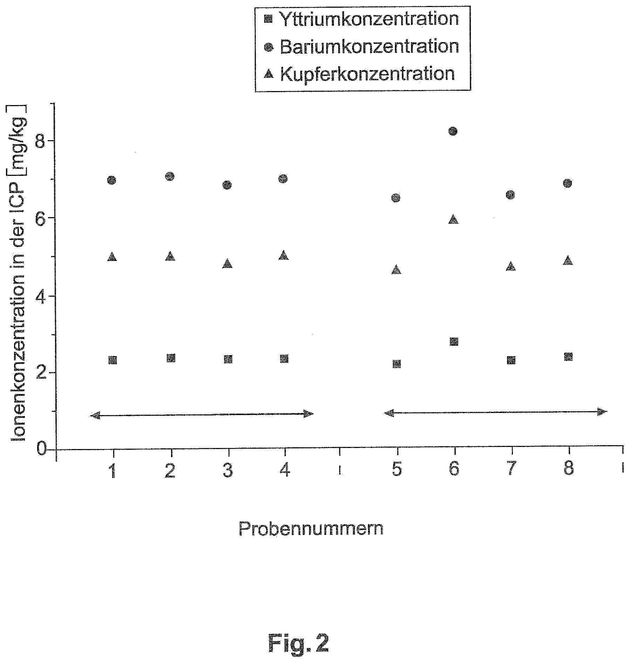

Ein Teil der gereinigten Schicht wird mittels verdünnter Salpetersäure in Lösung gebracht und mittels ICP-OES (Inductively Coupled Plasma - Optical Emission Spectroscopy) analysiert. Die Reinigungs- bzw. Spüllösung wird ebenfalls analysiert. Fig. 2 zeigt Meßergebnisse zu ungereinigten Proben (Probennummern 1 bis 4) sowie Proben nach Ultraschallbehandlung (Probennummern 5 bis 8).

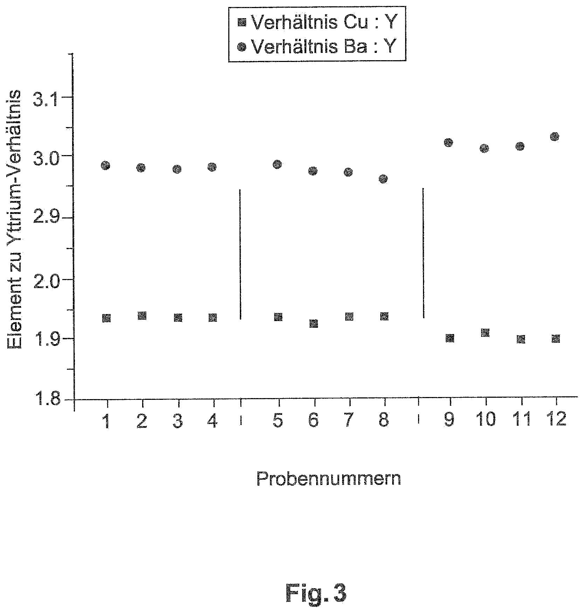

Während keine messbaren Stöchiometrieveränderungen in den Schichten zu erkennen sind, weicht die komplementäre Zusammensetzung der (aufkonzentrierten) Spüllösung ab, wobei sich die folgenden atomaren Verhältnisse ergeben: Y : Ba : Cu = 1 : 4,4 : 5,8 . Fig. 3 zeigt das Ergebnis von ICP-Messungen in pyrolysierten Schichten. Die Probennummern 1 bis 4 betreffen Einfachschichten, die Probennummern 5 bis 6 betreffen Einfachschichten mit UltraschallReinigung, die Probennummern 9 bis 12 betreffen Doppelschichten. Es zeigt sich, dass durch Abtragen der Grenzschicht durch Ultraschallbehandlung in Ethanol verstärkt ein Kupfer- und Bariumverlust bewirkt wird.

Die bestimmte absolute Metallmenge in der Reinigungslösung ergibt eine Abnahme der Gesamtschichtdicke durch die Reinigung von 10-15 nm. In diesen oberen 10-15 nm der pyrolysierten ungereinigten Schicht ergibt sich damit ein deutlicher Kupfer- und Bariumüberschuss, der wie folgt zu definieren ist:
(Ba + Cu): Y = 5 : 1 (HTS-Stöchiometrie)
(Ba + Cu): Y = 10 : 1 (Stöchiometrie Grenzschicht)

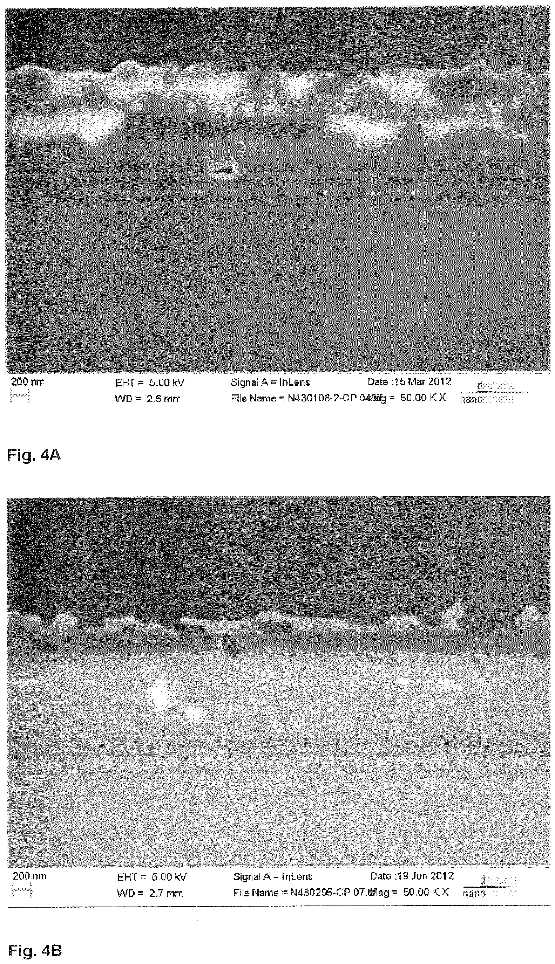

Fig. 4A schließlich zeigt ein SEM-Bild einer Doppelschicht nach Kristallisation, aber ohne Zwischenreinigung, während Fig. 4B dieselbe Doppelschicht nach Kristallisation, aber mit Zwischenreinigung zeigt. Die Unterschiede sind evident.

Untersuchungen haben gezeigt, dass ein optimales Durchwachsen der Grenzschicht nur gegeben ist, wenn das Verhältnis (Ba + Cu) : Y in der Grenzschicht (obere 10 nm der pyrolysierten Schicht vor dem Auftrag der Folgeschicht) unter 8, bevorzugt unter 6 liegt.

### Beispiel 2

Bei dem ansonsten zu Beispiel 1 gleichen Beispiel wurde die Abtragung der Grenzschicht anstatt mit Ultraschall durch gegenläufig rotierende Bürsten sowie durch auf das Band gerichtete Hochdruckschlitzdüsen erreicht. Als Lösungsmittel wurde ebenfalls Ethanol verwendet, identische Ergebnisse ergaben sich jedoch auch mit Methanol und Isopropanol. Die Behandlungszeit lag ebenfalls bei 2 min.

Die Analyseergebnisse (FIB-TEM) waren weitgehend vergleichbar, aufgrund der großen Lösungsmittelmenge konnte jedoch keine ICP-OES-Analyse durchgeführt werden. TEM-DEX-Messungen zeigten jedoch wieder ein Verhältnis (Ba + Cu) : Y von >9 in den oberen 10 nm der pyrolysierten ungereinigten Grenzschicht und von <7 nach der Behandlung. Die Ergebnisse der Doppelschichtkristallisation waren analog zu den Ergebnissen in Beispiel 1.

### Beispiel 3

In dem ansonsten zu Beispiel 1 gleichen Beispiel wurde die Abtragung der Grenzschicht nicht mechanisch (wie in Beispiel 2), sondern komplexometrisch unterstützt. Durch Zugabe von NaCN in die ethanolische Spüllösung (1 Gew.-%) wird insbesondere die Abtragung und Komplexierung von Kupfer begünstigt. Die Behandlung erfolgt im Gegenstrom in einer kontinuierlichen Anlage ohne weitere mechanische Unterstützung.

Die ICP-OES-Analyse der Spüllösung weist ein Metallverhältnis von Y : Ba : Cu von 1 : 2,8 : 7,3 auf. Kupfer wurde also bevorzugt abgetragen und gelöst.

Wieder ergibt sich damit ein ähnliches Verhältnis (Ba + Cu) : Y von >10 in den oberen 10 nm der pyrolysierten Grenzschicht und von <7 nach der Behandlung.

Die Ergebnisse der Doppelschichtkristallisation waren analog zu den Ergebnissen in Beispiel 1.

### Beispiel 4

Mit dem erfindungsgemäßen Verfahren kann nicht nur eine Homogenisierung der Teilschichten vor gemeinsamer Kristallisation erreicht werden, sondern auch eine gezielte Stöchiometrievariation innerhalb einer gemeinsam kristallisierten Schicht.

Im vorliegenden Beispiel wird eine nach der Kristallisation ca. 1000 nm dicke Gesamtschicht gezielt mit zwei unterschiedlichen Abscheidungsschritten und zwei unterschiedlichen stöchiometrischen Zusammensetzungen aufgetragen. Dabei wird zunächst eine Ba-verarmte YBCO-Teilschicht aufgetragen, um die orientierte Nukleation an der Grenzfläche zum Substrat zu begünstigen. Nach Trocknung, Pyrolyse und erfindungsgemäßer Entfernung der Grenzschicht wird darüber eine YBCO-Schicht mit weniger oder ohne Bariumdefizit aufgebracht, die optimierte Eigenschaften für das Kristallwachstum besitzt.

Abschließend wird die Gesamtschicht gemeinsam kristallisiert. Die Verfahrensbedingungen für Abscheidung, Trocknung, Pyrolyse und Kristallisation entsprechen denjenigen, die oben in Beispiel 1 näher beschrieben sind.

Durch zwischenzeitliche Entfernung der Grenzschicht können ein komplett texturiertes Kristallwachstum erreicht und damit die positiven Eigenschaften der Teilschichten vereinigt werden.

## Patentansprüche

1. Verfahren zur Herstellung eines Komposits umfassend eine Hochtemperatursupraleiter(HTS)-Schicht auf Basis von Seltenerdmetall-Barium-Kupferoxid auf einem Substrat mit vorgegebener biaxialer Textur, mit folgenden Schritten:
A) Aufbringen einer ersten HTS-Beschichtungslösung auf das Substrat;
B) Trocknen der ersten HTS-Beschichtungslösung zur Herstellung eines ersten Films;
C) Pyrolysieren des ersten Films zur Herstellung einer ersten pyrolysierten Teilschicht;
D) Abtragen einer Grenzschicht auf der Oberseite der ersten pyrolysierten Teilschicht zur Herstellung einer ersten pyrolysierten Teilschicht mit reduzierter Schichtdicke;
E) Aufbringen einer zweiten HTS-Beschichtungslösung auf der ersten pyrolysierten Teilschicht mit reduzierter Schichtdicke;
F) Trocknen der zweiten HTS-Beschichtungslösung zur Herstellung eines zweiten Films;
G) Pyrolysieren des zweiten Films zur Herstellung einer zweiten pyrolysierten Teilschicht;
H) gegebenenfalls Ausbilden einer oder mehrerer weiterer pyrolysierter Teilschichten auf der zweiten pyrolysierten Teilschicht;und
I) Kristallisieren der aus den pyrolysierten Teilschichten gebildeten Gesamtschicht zur Fertigstellung der HTS-Schicht,
wobei das Abtragen der Grenzschicht in Schritt D) so erfolgt, dass in die erste und auch in die zweite pyrolysierte Teilschicht eine Textur übertragen wird, welche durch die vorgegebene biaxiale Textur des Substrats bestimmt ist.

2. Verfahren nach Anspruch 1, **dadurch gekennzeichnet, dass** Schritt H) durchgeführt wird, wobei unmittelbar zuvor ein Abtragen einer Grenzschicht auf der Oberseite der jeweils vorherigen, zweiten oder weiteren pyrolysierten Teilschicht erfolgt.

3. Verfahren nach Anspruch 1 oder 2, **dadurch gekennzeichnet, dass** in Schritt D) soviel von der ersten pyrolysierten Teilschicht als Grenzschicht abgetragen wird, dass nach dem Abtragen der Mittelwert des atomaren Verhältnises (Ba + Cu) : Y in den oberen 10 nm der ersten pyrolysierten Teilschicht unter 8 liegt und/oder vor Schritt H) soviel von der jeweils vorherigen, zweiten oder weiteren pyrolysierten Teilschicht.als Grenzschicht abgetragen wird, dass nach dem Abtragen der Mittelwert des atomaren Verhältnisses (Ba + Cu) : Y in den oberen 10 nm der jeweils vorherigen, zweiten oder weiteren Teilschicht unter 8 liegt.

4. Verfahren nach einem der Ansprüche 1 bis 3, **dadurch gekennzeichnet, dass** in Schritt D) 1 bis 20% der ersten pyrolysierten Teilschicht als Grenzschicht abgetragen werden, bezogen auf die Schichtdicke der ersten pyrolysierten Teilschicht, und/oder vor Schritt H) 1 bis 20% der jeweils vorherigen, zweiten oder weiteren pyrolysierten Teilschicht als Grenzschicht abgetragen werden, bezogen auf die Schichtdicke der jeweils vorherigen, zweiten oder weiteren Teilschicht.

5. Verfahren nach einem der vorangehenden Ansprüche, **dadurch gekennzeichnet, dass** das Abtragen der Grenzschicht auf mechanischem, chemischem und/oder physikalischem Wege erfolgt.

6. Verfahren nach Anspruch 5, **dadurch gekennzeichnet, dass** das Abtragen der Grenzschicht durch Ultraschall, Abrasion, Bestrahlung, Ätzen, Beizen, Plasmaätzen oder Lösen in einem geeigneten Lösungsmittel erfolgt, gegebenenfalls in Kombination miteinander oder mit anderen mechanischen, chemischen oder physikalischen Behandlungsschritten.

7. Verfahren nach einem der vorangehenden Ansprüche, **dadurch gekennzeichnet, dass** als HTS-Beschichtungslösung eine Lösung zur Ausbildung einer Yttrium-Barium-Kupferoxid-Schicht verwendet wird.

8. Verfahren nach einem der vorangehenden Ansprüche, **dadurch gekennzeichnet, dass** insgesamt 2, 3, 4 oder 5 pyrolysierte Teilschichten ausgebildet werden.

9. Verfahren nach einem der vorangehenden Ansprüche, **dadurch gekennzeichnet, dass** die Zusammensetzungen der jeweiligen Beschichtungslösungen unterschiedlich sind.

10. Verfahren nach einem der vorangehenden Ansprüche, **dadurch gekennzeichnet, dass** die pyrolysierten Teilschichten in unterschiedlichen Schichtdicken ausgebildet werden.

11. Verfahren nach einem der vorangehenden Ansprüche, **dadurch gekennzeichnet, dass** die Schichtdicken der pyrolysierten Teilschichten zwischen 400 und 800 nm liegen.

12. Komposit, umfassend auf einem Substrat (10) mit vorgegebener Textur eine Hochtemperatursupraleiter(HTS)-Schicht (20) umfassend Seltenerd-Barium-Kupferoxid,
wobei
- die HTS-Schicht (20) aus mehreren aufeinander abgeschiedenen Teilschichten (21, 22, 23, 24) besteht,
- in jeder der Teilschichten (21, 22, 23, 24) in Richtung senkrecht zur Substratoberfläche das atomare Verhältnis (Ba + Cu) : Y variiert und
- in jeder der Teilschichten (21, 22, 23, 24), mit oder ohne Ausnahme der obersten Teilschicht (24), jede sich parallel zur Substratoberfläche erstreckende Sub-Schicht (30) einer Dicke von 10 nm so konstituiert ist, dass der Mittelwert des besagten atomaren Verhältnisses kleiner oder gleich 8 ist.

13. Komposit nach Anspruch 12, herstellbar mit einem Verfahren gemäß einem der Ansprüche 1 bis 11.

14. Komposit nach Anspruch 13, **dadurch gekennzeichnet, dass** die Gesamtschicht aus pyrolysierten Teilschichten nach dem Kristallisieren in Schritt I) in mehr als 80% des Volumens eine Textur aufweist, die durch die vorgegebene Textur des Substrats definiert ist.

15. Komposit nach einem der Ansprüche 12 bis 14, **dadurch gekennzeichnet, dass** es ein bandförmiger HTS ist.

## Claims

1. A method for producing a composite comprising a high-temperature superconductor (HTS) layer based on rare earth metal-barium-copper oxide on a substrate with defined biaxial texture, having the following steps:
A) applying a first HTS coating solution to the substrate;
B) drying the first HTS coating solution to produce a first film;
C) pyrolyzing the first film to produce a first pyrolyzed sublayer;
D) removing an interfacial layer on the upper side of the first pyrolyzed sublayer to produce a first pyrolyzed sublayer with reduced layer thickness;
E) applying a second HTS coating solution to the first pyrolyzed sublayer with reduced layer thickness;
F) drying the second HTS coating solution to produce a second film;
G) pyrolyzing the second film to produce a second pyrolyzed sublayer;
H) optionally forming one or more further pyrolyzed sublayers on the second pyrolyzed sublayer; and
I) crystallizing the overall layer formed from the pyrolyzed sublayers to complete the HTS layer,
wherein the removal of the interfacial layer in step D) is effected in such a way that a texture determined by the defined biaxial texture of the substrate is transferred to the first and also to the second pyrolyzed sublayer.

2. The method according to claim 1, wherein step H) is implemented, with immediately preceding removal of an interfacial layer on the upper side of the respective previous second or further pyrolyzed sublayer.

3. The method according to claim 1 or 2, wherein a sufficient amount of the first pyrolyzed sublayer as interfacial layer is removed in step D) that, after the removal, the mean atomic (Ba + Cu):Y ratio in the upper 10 nm of the first pyrolyzed sublayer is below 8 and/or step H) is preceded by removal of a sufficient amount of the respective previous second or further pyrolyzed sublayer as interfacial layer that, after the removal, the mean atomic (Ba + Cu):Y ratio in the upper 10 nm of the respective previous second or further sublayer is below 8.

4. The method according to any of claims 1 to 3, wherein 1% to 20% of the first pyrolyzed sublayer as interfacial layer is removed in step D), based on the layer thickness of the first pyrolyzed sublayer, and/or step H) is preceded by removal of 1% to 20% of the respective previous second or further pyrolyzed sublayer as interfacial layer, based on the layer thickness of the respective previous second or further sublayer.

5. The method according to any of the preceding claims, wherein the removal of the interfacial layer is effected in a mechanical, chemical and/or physical manner.

6. The method according to claim 5, wherein the removal of the interfacial layer is effected by ultrasound, abrasion, irradiation, etching, pickling, plasma etching or dissolving in a suitable solvent, optionally in combination with one another or with other mechanical, chemical or physical treatment steps.

7. The method according to any of the preceding claims, wherein the HTS coating solution used is a solution for formation of an yttrium-barium-copper oxide layer.

8. The method according to any of the preceding claims, wherein a total of 2, 3, 4 or 5 pyrolyzed sublayers is formed.

9. The method according to any of the preceding claims, wherein the compositions of the respective coating solutions are different.

10. The method according to any of the preceding claims, wherein the pyrolyzed sublayers are formed in different layer thicknesses.

11. The method according to any of the preceding claims, wherein the layer thicknesses of the pyrolyzed sublayers are between 400 and 800 nm.

12. A composite comprising, on a substrate (10) with defined texture, a high-temperature superconductor (HTS) layer (20) comprising rare earth-barium-copper oxide,
wherein
- the HTS layer (20) consists of a plurality of sublayers (21, 22, 23, 24) deposited one on top of another,
- in each of the sublayers (21, 22, 23, 24) there is variation in the atomic (Ba + Cu):Y ratio in the direction at right angles to the substrate surface and
- in each of the sublayers (21, 22, 23, 24), with or without the exception of the uppermost sublayer (24), every sublayer (30) of thickness 10 nm that extends parallel to the substrate surface is constituted such that the mean of said atomic ratio is not more than 8.

13. The composite according to claim 12, producible by a method according to any of claims 1 to 11.

14. The composite according to claim 13, wherein the overall layer composed of pyrolyzed sublayers after the crystallizing in step I), in more than 80% of the volume, has a texture defined by the defined texture of the substrate.

15. The composite according to any of claims 12 to 14, which is an HTS in ribbon form.

## Revendications

1. Procédé de fabrication d'un composite comprenant une couche de supraconducteur à haute température (HTS) à base d'un oxyde de métal de terres rares-baryum-cuivre sur un substrat à structure biaxiale prédéfinie, comprenant les étapes suivantes :
A) l'application d'une première solution de revêtement HTS sur le substrat ;
B) le séchage de la première solution de revêtement HTS pour la formation d'un premier film ;
C) la pyrolyse du premier film pour la formation d'une première couche partielle pyrolysée ;
D) l'élimination d'une couche de bordure sur le côté supérieur de la première couche partielle pyrolysée pour la formation d'une première couche partielle pyrolysée d'épaisseur de couche réduite ;
E) l'application d'une deuxième solution de revêtement HTS sur la première couche partielle pyrolysée d'épaisseur de couche réduite ;
F) le séchage de la deuxième solution de revêtement HTS pour la formation d'un deuxième film ;
G) la pyrolyse du deuxième film pour la formation d'une deuxième couche partielle pyrolysée ;
H) éventuellement la formation d'une ou de plusieurs couches partielles pyrolysées ultérieures sur la deuxième couche partielle pyrolysée ; et
I) la cristallisation de la couche totale formée par les couches partielles pyrolysées pour la finition de la couche HTS,
l'élimination de la couche de bordure à l'étape D) ayant lieu de sorte qu'une texture, qui est déterminée par la texture biaxiale prédéfinie du substrat, soit transférée dans la première et également dans la deuxième couche partielle pyrolysée.

2. Procédé selon la revendication 1, **caractérisé en ce que** l'étape H) est réalisée, une élimination d'une couche de bordure sur le côté supérieur de la deuxième couche partielle pyrolysée ou d'une couche partielle pyrolysée ultérieure, à chaque fois précédente, ayant lieu immédiatement avant.

3. Procédé selon la revendication 1 ou 2, **caractérisé en ce qu'**à l'étape D), une quantité telle de la première couche partielle pyrolysée est éliminée en tant que couche de bordure qu'après l'élimination, la valeur moyenne du rapport atomique (Ba+Cu):Y dans les 10 nm supérieurs de la première couche partielle pyrolysée soit inférieur à 8, et/ou, avant l'étape H), une quantité telle de la deuxième couche partielle pyrolysée ou d'une couche partielle pyrolysée ultérieure, à chaque fois précédente, est éliminée en tant que couche de bordure qu'après l'élimination, la valeur moyenne du rapport atomique (Ba+Cu):Y dans les 10 nm supérieurs de la deuxième couche partielle ou d'une couche partielle ultérieure, à chaque fois précédente, soit inférieur à 8.

4. Procédé selon l'une quelconque des revendications 1 à 3, **caractérisé en ce qu'**à l'étape D), 1 à 20 % de la première couche partielle pyrolysée est éliminée en tant que couche de bordure, par rapport à l'épaisseur de couche de la première couche partielle pyrolysée et/ou, avant l'étape H), 1 à 20 % de la deuxième couche partielle pyrolysée ou d'une couche partielle pyrolysée ultérieure, à chaque fois précédente, est éliminée en tant que couche de bordure, par rapport à l'épaisseur de couche de la deuxième couche partielle ou d'une couche partielle ultérieure, à chaque fois précédente.

5. Procédé selon l'une quelconque des revendications précédentes, **caractérisé en ce que** l'élimination de la couche de bordure a lieu par voie mécanique, chimique et/ou physique.

6. Procédé selon la revendication 5, **caractérisé en ce que** l'élimination de la couche de bordure a lieu par ultrason, abrasion, exposition à un rayonnement, gravure, décapage, gravure par plasma ou dissolution dans un solvant approprié, éventuellement en combinaison les uns avec les autres ou avec d'autres étapes de traitement mécaniques, chimiques ou physiques.

7. Procédé selon l'une quelconque des revendications précédentes, **caractérisé en ce qu'**une solution pour la formation d'une couche d'oxyde d'yttrium-baryum-cuivre est utilisée en tant que solution de revêtement HTS.

8. Procédé selon l'une quelconque des revendications précédentes, **caractérisé en ce qu'**au total 2, 3, 4 ou 5 couches partielles pyrolysées sont formées.

9. Procédé selon l'une quelconque des revendications précédentes, **caractérisé en ce que** les compositions des solutions de revêtement respectives sont différentes.

10. Procédé selon l'une quelconque des revendications précédentes, **caractérisé en ce que** les couches partielles pyrolysées sont formées en différentes épaisseurs de couche.

11. Procédé selon l'une quelconque des revendications précédentes, **caractérisé en ce que** les épaisseurs de couche des couches partielles pyrolysées sont comprises entre 400 et 800 nm.

12. Composite, comprenant sur un substrat (10) à texture prédéfinie une couche de supraconducteur à haute température (HTS) (20) comprenant un oxyde de terre rare-baryum-cuivre, dans lequel
- la couche HTS (20) est constituée par plusieurs couches partielles (21, 22, 23, 24) déposées les unes sur les autres,
- dans chacune des couches partielles (21, 22, 23, 24), le rapport atomique (Ba+Cu):Y varie dans la direction perpendiculaire à la surface du substrat, et
- dans chacune des couches partielles (21, 22, 23, 24), avec ou sans exclusion de la couche partielle supérieure (24), chacune sous-couche (30) s'étendant parallèlement à la surface du substrat d'une épaisseur de 10 nm est constituée de sorte que la valeur moyenne dudit rapport atomique soit inférieure ou égale à 8.

13. Composite selon la revendication 12, pouvant être fabriqué par un procédé selon l'une quelconque des revendications 1 à 11.

14. Composite selon la revendication 13, **caractérisé en ce que** la couche totale constituée par les couches partielles pyrolysées présente après la cristallisation à l'étape I) dans plus de 80 % du volume une texture qui est définie par la texture prédéfinie du substrat.

15. Composite selon l'une quelconque des revendications 12 à 14, **caractérisé en ce qu'**il s'agit d'un HTS en forme de bande.
